# EUROPEAN PATENT APPLICATION

(11) **EP 1 197 942 A2**
(43) Date of publication of application: **17.04.2002**
(21) Application number: 01308001.5
(22) Date of filing: 19.09.2001
(51) Int. Cl.: G09G 3/32

(54) **Method of driving organic electroluminescence element, apparatus for driving organic electroluminescence element and display using the same**

(30) Priority: 22.09.2000 JP 2000288011
(71) Applicant: Sanyo Electric Co., Ltd., Moriguchi-shi, Osaka 570-8677 (JP)
(72) Inventor: Tsujioka, Tsuyoshi, Sanyo Electric Co., Ltd., Moriguchi-shi, Osaka 570-8677 (JP); Hamada, Yuji, Sanyo Electric Co., Ltd., Moriguchi-shi, Osaka 570-8677 (JP); Fuji, Hiroyuki, Sanyo Electric Co., Ltd., Moriguchi-shi, Osaka 570-8677 (JP)
(74) Representative: Calderbank, Thomas Roger

(57) **Abstract**

A pulse voltage application circuit applies a pulse voltage having a duty ratio of not more than 10 % to an organic EL element. In this case, driving conditions are set such that an average drive current flowing through the organic EL element (an average injection current density) is not more than 3 mA/cm², and an average drive voltage applied to the organic EL element is not more than 4 volts.

## Description

The present invention relates to a method of driving an organic electroluminescence element, an apparatus for driving an organic electroluminescence element and a display using the same.

In recent years, the needs for flat panel displays whose power consumption is lower than that of CRTs (Cathode-Ray Tubes) which have been generally employed have increased as information equipment is diversified. As one type of the flat panel displays, displays using organic electroluminescence elements (hereinafter referred to as organic EL elements) have been actively studied and developed. The displays using the organic EL elements have some features. For example, they have an intermediate or high efficiency, are thin and lightweight, and have no viewing angle dependency.

In an organic EL element, electrons and holes are injected into a luminescent portion, respectively, from an electron injection electrode and a hole injection electrode, the electrons and the holes are recombined at a luminescent center to bring an organic molecule into an excited state, and fluorescence is emittied when the organic molecule is returned from the excited state to a ground state. Displays using such organic EL elements have a structure in which a plurality of organic EL elements are arranged in the form of a matrix on a substrate.

The organic EL elements have the advantage in that they can be driven at low voltages of 5 volts to 20 volts. Further, it is expected that the organic EL elements which emit light in suitable colors can be obtained by selecting fluorescent materials which are luminescent materials, and are also utilized as multi-color or full-color displays.

In order to apply the organic EL elements to high definition displays, two systems have been examined. One of them is a simple matrix system (a passive system), in which a plurality of transparent anodes and a plurality of transparent cathodes which are composed of ITO (Indium Tin Oxide) are arranged so as to cross each other, an organic layer is interposed between the anode and the cathode which cross each other, and carriers are injected into the organic layer by applying a voltage between the two electrodes to emit light. A display constructed by such a simple matrix system is also reported in 9th International Workshop on Inorganic and Organic Electroluminescence Sep.14-18, 1998, Oregon : Extended Abstracts pp.137-140.

The other is an active matrix system, in which a plurality of TFTs (Thin Film Transistors) composed of polycrystalline silicon are formed on a substrate, and an organic layer is formed on a circuit composed of the TFTs, to turn on and off each of organic EL elements serving as pixels by turning the corresponding TFT on and off. A capacitor is connected to each of the TFTs.

In the simple matrix system, only when a voltage is applied between the electrodes in each of the organic EL elements, the organic EL element is turned on. In a display having a QVGA specification having a resolution of 320 dots in width by 240 dots in length, for example, therefore, even when pixels on one line are simultaneously turned on, one of the pixels is driven at a duty ratio of 1 : 240 when one frame is displayed.

On the other hand, in the active matrix system, the TFT corresponding to the one pixel can hold an on state for a long time by charges stored in the capacitor. When one frame is displayed, therefore, each of the organic EL elements is turned on in a state almost close to DC driving.

In order to maintain the same brightness, therefore, in the simple matrix system, each of the organic EL elements must instantaneously emit light in brightness which is 240 times that in the active matrix system. That is, in the simple matrix system, a current which is approximately 240 times that in the active matrix system must be instantaneously caused to flow through each of the organic EL elements.

It has been recognition common among researchers in the technical field to cause a large current to instantaneously flow through an organic EL element by pulse driving at a low duty ratio is a factor which reduces the lives of a luminescent material and the organic EL element, as described on page 58 of "Nikkei Electronics 2000. 3. 13. (no. 765)", for example. That is, it has been considered that in pulse driving at a low duty ratio, the peak value of a drive current must be increased in order to obtain predetermined average luminance, imposing a burden on the element so that the life of the element is reduced.

It is recognized among those skilled in the art that the life of the organic EL element is thus reduced when the organic EL element is pulse-driven at a low duty ratio. Therefore, it has been considered that a high definition display is difficult to construct in a simple matrix system.

An object of the present invention is to provide a method of and an apparatus for driving an organic electroluminescence element in which long life can be attained in pulse driving at a low duty ratio, and a display using the same.

It has been recognized among those skilled in the art that it is not desirable to pulse-drive an organic electroluminescence element at a low duty ratio because its life is reduced, as described above. However, the inventors of the present application have obtained the knowledge that the above-mentioned recognition does not necessarily hold, and the life of the organic electroluminescence element is improved by conversely pulse driving at a low duty ratio under particular conditions as a result of repeating zealous experiments and examination with respect to the relationship between the duty ratio of a pulse voltage and the life of the element. The following invention has been contrived on the basis of the knowledge.

A method of driving an organic electroluminescence element including an organic material layer according to an aspect of the present invention comprises the step of applying a pulse voltage having a duty ratio of not more than 10 % between electrodes in the organic electroluminescence element, setting an average drive current flowing through the organic electroluminescence element to not more than 3 mA/cm², and setting an average drive voltage applied between the electrodes in the organic electroluminescence element to not more than 4 volts.

Here, "duty ratio" is defined as the ratio of the duration of a high level of voltage to one period of a pulse voltage in percent.

In the driving method according to the present invention, when the pulse voltage is applied between the electrodes in the organic electroluminescence element, the current flows through the organic electroluminescence element, so that the organic electroluminescence element intermittently emits light.

In this case, the organic electroluminescence element is pulse-driven under driving conditions , that is , a duty ratio of not more than 10 %, an average drive current of not more than 3 mA/cm², and an average drive voltage of not more than 4 volts, thereby attaining long life of the organic electroluminescence element in the pulse driving at a low duty ratio.

It is preferable that the average drive voltage is not more than 1 volt. Consequently, the life of the organic electroluminescence element is further improved.

It is preferable that the organic material layer includes an aluminum quinolinol complex. In this case, the life of the organic electroluminescence element is improved by the above-mentioned driving conditions.

A driving apparatus for driving an organic electroluminescence element including an organic material layer according to another aspect of the present invention comprises a pulse voltage application circuit for applying a pulse voltage having a duty ratio of not more than 10 % between electrodes in the organic electroluminescence element, an average drive current flowing through the organic electroluminescence element being set to not more than 3 mA/cm², and an average drive voltage applied between the electrodes in the organic electroluminescence element being set to not more than 4 volts.

In the driving apparatus according to the present invention, the organic electroluminescence element is pulse-driven under driving conditions, that is, a duty ratio of not more than 10 %, an average drive current of not more than 3 mA/cm², and an average drive voltage of not more than 4 volts, thereby attaining long life of the organic electroluminescence element in the pulse driving at a low duty ratio.

It is preferable that the average drive voltage is set to not more than 1 volt. Consequently, the life of the organic electroluminescence element is further improved.

It is preferable that the organic electroluminescence element comprises an organic material layer containing an aluminum quinolinol complex. In this case, the life of the organic electroluminescence element is improved by the above-mentioned driving conditions.

A display according to still another aspect of the present invention comprises one or a plurality of organic electroluminescence elements including an organic material layer, and a driving device for applying a pulse voltage having a duty ratio of not more than 10 % between electrodes in each of the organic electroluminescence elements, an average drive current flowing through each of the organic electroluminescence elements being set to not more than 3 mA/cm², and an average drive voltage applied between the electrodes in each of the organic electroluminescence elements being set to not more than 4 volts.

In the display according to the present invention, each of the organic electroluminescence elements is pulse-driven under driving conditions, that is, a duty ratio of not more than 10 %, an average drive current of not more than 3 mA/cm², and an average drive voltage of not more than 4 volts, thereby attaining long life of the organic electroluminescence element in the pulse driving at a low duty ratio.

Particularly, it is preferable that the driving device is a driving device of a simple matrix system. In this case, even when each of the organic electroluminescence elements is pulse-driven at a low duty ratio, long life of the organic electroluminescence element is attained. Accordingly, a high definition display can be realized in a simple matrix system.

It is preferable that the average drive voltage is not more than 1 volt. Consequently, the life of the organic electroluminescence element is further improved.

It is preferable that the organic material layer contains an aluminum quinolinol complex. In this case, the life of the organic electroluminescence element is improved by the above-mentioned driving conditions.

The foregoing and other objects, features, aspects and advantages of the present invention will become more apparent from the following detailed description of the present invention when taken in conjunction with the accompanying drawings.

### IN THE DRAWINGS:

Fig. 1 is a schematic view showing an example of the structure of an organic EL element and a pulse voltage application circuit;
Fig. 2 is a diagram showing the results of measurement of the duty ratio dependency of the life of an organic EL element in an embodiment 1;
Fig. 3 is a diagram showing the relationship between an average drive voltage and life;
Fig. 4 is a diagram showing the results of measurement of the duty ratio dependency of the life of an organic EL element in an embodiment 2;
Fig. 5 is a diagram showing the results of measurement of the duty ratio dependency of the life of an organic EL element in an embodiment 3;
Fig. 6 is a diagram showing the results of measurement of the duty ratio dependency of the life of an organic EL element in an embodiment 4;
Fig. 7 is a diagram showing the results of measurement of the duty ratio dependency of the life of an organic EL element in an embodiment 5;
Fig. 8 is a diagram showing the relationship between the initial value of an average drive current and life; and
Fig. 9 is a block diagram showing an example of the configuration of a display of a simple matrix system using a driving device according to the present invention.

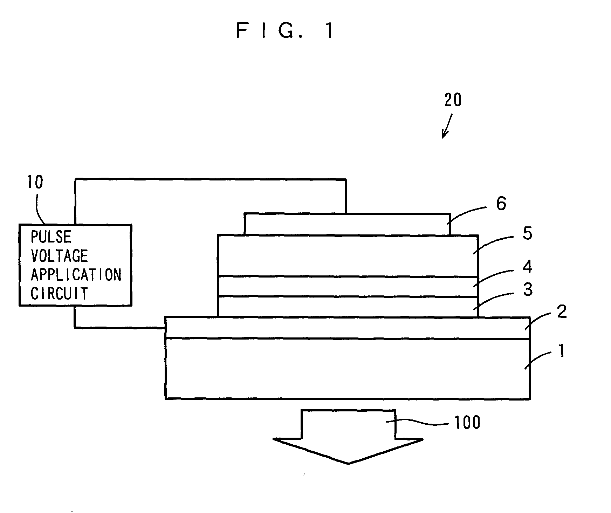

Fig. 1 is a schematic view showing an example of the structure of an organic electroluminescence element (hereinafter referred to as an organic EL element) and a pulse voltage application circuit.

In an organic EL element 20 shown in Fig. 1, an anode (a hole injection electrode) 2 composed of a transparent conductive film is formed on a glass substrate 1. A hole injection layer 3 composed of an organic material, a hole transport layer 4 composed of an organic material, and a luminescent layer 5 composed of an organic material are formed in this order on the anode 2. A cathode (an electron injection electrode) 6 is formed on the luminescent layer 5.

The structure of the organic EL element 20 is not limited to the structure shown in Fig. 1. Various structures can be used. For example, a luminescent layer composed of an organic material may be provided in place of the hole transport layer 4, and an electron transport layer composed of an organic material may be provided in place of the luminescent layer 5.

A pulse voltage application circuit 10 is connected between the anode 2 and the cathode 6 in the organic EL element 20. The pulse voltage application circuit 10 applies a pulse voltage to the organic EL element 20, so that the luminescent layer 5 in the organic EL element 20 emits light, and light 100 is emitted form the reverse surface of the glass substrate 1.

In the present embodiment, the pulse voltage application circuit 10 applies a pulse voltage having a duty ratio of not more than 10 % to the organic EL element 20. In this case, driving conditions are set such that an average drive current flowing through the organic EL element 20 (an average injection current density) is not more than 3 mA/cm², and an average drive voltage applied to the organic EL element 20 is not more than 4 volts. Consequently, long life of the organic EL element 20 is attained in pulse driving at a low duty ratio, as apparent from the following examples.

### [Examples]

The duty ratio dependency of life, the relationship between the life and an average drive voltage, and the relationship between the life and an average drive current were measured using organic EL elements in examples 1 to 5.

### [Example 1]

In the example 1, an anode 2 composed of ITO which is a transparent conductive film was formed on a glass substrate 1, a hole injection layer 3 having a thickness of 500 Å composed of 2-TNATA (4, 4', 4" - tris (2-naphthylphenylamino) triphenyl - amine) having a molecular structure of a chemical formula (1), a hole transport layer 4 having a thickness of 20 Å composed of α - NPB ( α - N,N' - Di(naphthalene - 1 - y1) - N,N'-Di(phenyl - benzidine)) having a molecular structure of a chemical formula (2), and a luminescent layer 5 having a thickness of 400 Å composed of Alq₃ (Tris (8 - hydroxy-quinolinate) aluminum or Tris (8 - quinolinolato) aluminum) which is an aluminum chelate complex having a molecular structure of a chemical formula (3) were stacked on the anode 2 by vacuum evaporation, and a cathode 6 composed of Mg was formed on the luminescent layer 5. Consequently, an organic EL element emitting green light was obtained.

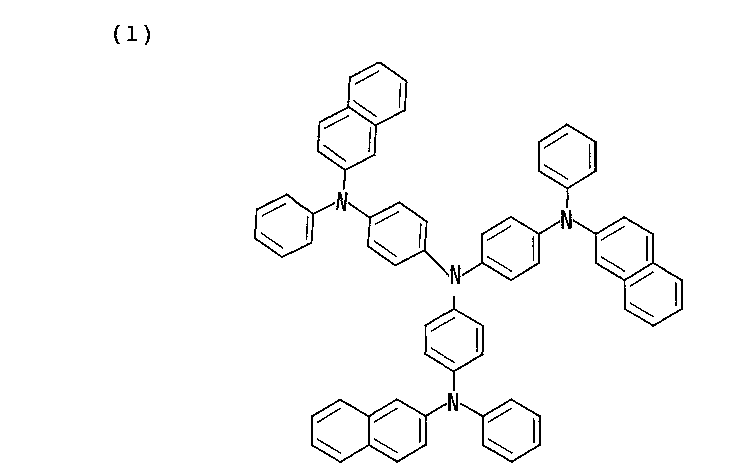

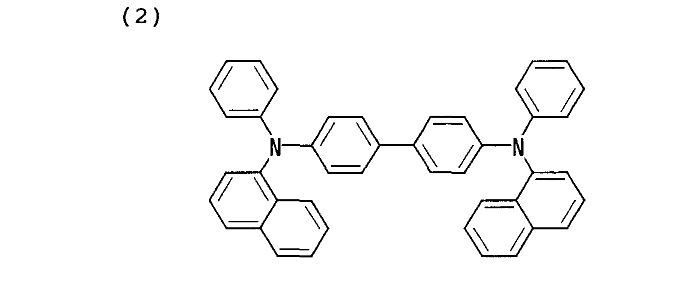

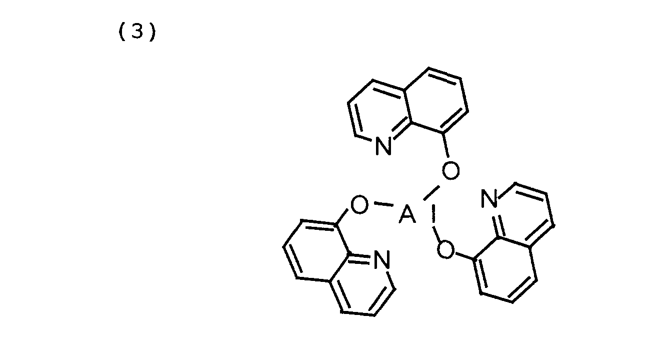

Continuous luminescence experiments were conducted at room temperature by applying a drive voltage to the organic EL element by a DC driving system and a pulse driving system, to examine the amount of luminance reduced with an elapse of time.

In the DC driving system, a predetermined voltage was continuously applied to the organic EL element. In the pulse driving system, a pulse voltage having a duty ratio of 50 %, a pulse voltage having a duty ratio of 10 %, and a pulse voltage having a duty ratio of 1 % were applied to the organic EL element. The frequency of the pulse voltage was set to 60 Hz. For example, in pulse driving at a duty ratio of 50 %, a voltage was applied to the organic EL element during a period which is 50 % of one period, to cause the organic EL element to emit light, and no voltage was applied to the organic EL element during a period which is the remaining 50 %, not to cause the organic EL element to emit light. In any of the DC driving, the pulse driving at a duty ratio of 50 %, the pulse driving at a duty ratio of 10 %, and the pulse driving at a duty ratio of 1 %, the driving conditions were adjusted such that the initial average luminance would be 100 cd/m². Further, the continuous luminescence experiments were conducted by constant voltage driving for keeping an average drive voltage constant.

The peak value of the drive voltage was 7.45 volts in the DC driving, 8.5 volts in the pulse driving at a duty ratio of 50 %, 10.5 V in the pulse driving at a duty ratio of 10 %, and 15.65 volts in the pulse driving at a duty ratio of 1 %. The average drive voltage was 7.45 volts in the DC driving, 4. 25 volts in the pulse driving at a duty ratio of 50 %, 1.05 volts in the pulse driving at a duty ratio of 10 %, and 0.1565 volts in the pulse driving at a duty ratio of 1 %.

The average drive voltage differs depending on the duty ratio. When the initial average luminance was set to an equal value, the initial value of an average drive current was approximately equal without depending on the duty ratio by the linear relationship between the luminance and the current. Under the above-mentioned driving conditions, the initial value of the average drive current (average injection current density) was approximately 3 mA/cm². The average drive current is reduced with an elapse of time.

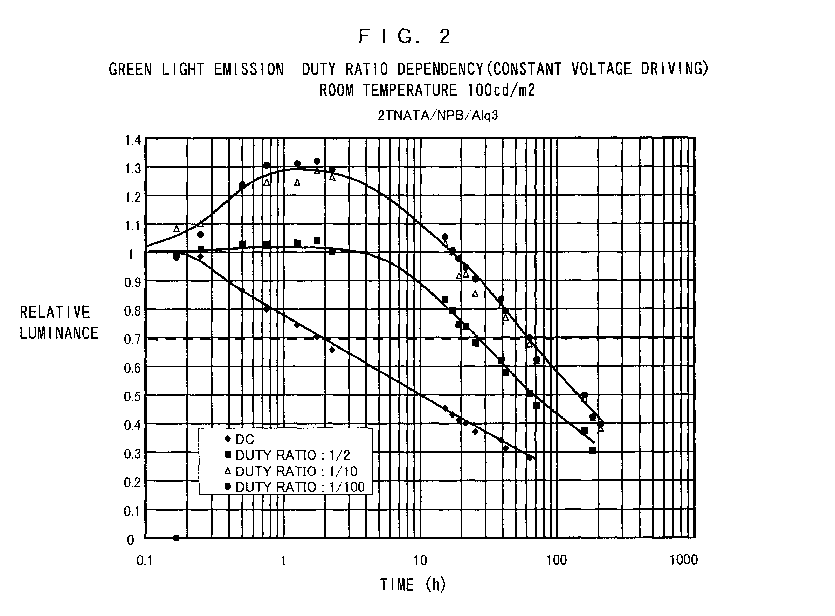

Fig. 2 is a diagram showing the results of measurement of the duty ratio dependency of the life of the organic EL element in the example 1. In Fig. 2, the horizontal axis represents time, and the vertical axis represents relative luminance in a case where the initial average luminance is set to one.

In Fig. 2, when the DC driving and the pulse driving at a duty ratio of 50 % were compared in a time period elapsed from the time when the continuous luminescence experiments are started until the luminance is reduced to 70 % of the initial average luminance (hereinafter referred to as 70 % life), the 70 % life was approximately 2 hours in the DC driving, while being lengthened to not less than 20 hours in the pulse driving at a duty ratio of 50 %. Further, the 70 % life was improved to approximately 60 hours in the pulse driving at a duty ratio of 10 % and the pulse driving at a duty ratio of 1 %.

It is thus found that when the duty ratio of the pulse voltage is not more than 10 %, the life is greatly improved irrespective of the increase in the peak value of the drive current.

The reason why in the pulse driving at a duty ratio of 10 % and the pulse driving at a duty ratio of 1 %, the luminance is temporarily increased immediately after the continuous luminescence experiments are started is that under the driving conditions, the element temperature rises because the peak value of the drive voltage is increased to increase the power consumption, so that the injection of carries into the luminescent layer 5 by a Schottky mechanism is promoted.

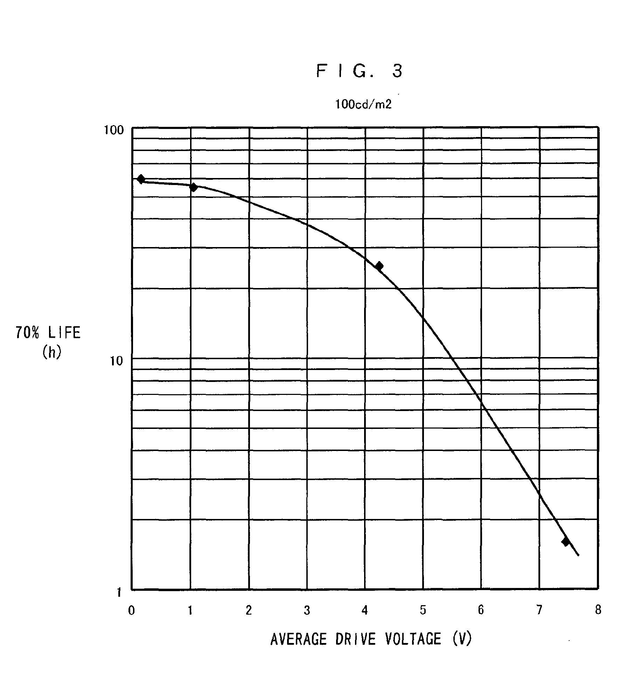

The relationship between an average drive voltage and life was then examined from the results shown in Fig. 2. Fig. 3 is a diagram showing the relationship between an average drive voltage and life. The horizontal axis shown in Fig. 3 represents the average drive voltage, and the vertical axis represents the 70 % life.

As shown in Fig. 3, the 70 % life was approximately 1.5 hours when the average drive voltage was 7.45 volts, while being lengthened to approximately 25 hours when the average drive voltage was 4.25 volts. The 70 % life was improved to approximately 55 hours when the average drive voltage was 1.05 volts, and was improved to approximately 60 hours when the average drive voltage was 1565 volts. From the results, it is found that the effect of preventing the initial luminance from being reduced is increased when the average drive voltage is not more than approximately 4 volts, and is further increased when the average drive voltage is not more than approximately 1 volt.

At the time of pulse driving at a duty ratio of 0.2 %, the effect of attaining long life as in pulse driving at a duty ratio of 10 % was also confirmed.

Although the above-mentioned continuous luminescence experiments were conducted by constant voltage driving for keeping the average drive voltage constant, the luminance is reduced by the degradation of the organic EL element with an elapse of time even in constant current driving for keeping the average drive current constant. Even in the constant current driving, the same effect of attaining long life was confirmed in pulse driving at a low duty ratio.

### [Example 2]

In the example 2, an organic EL element having the same element structure as that in the example 1 was fabricated, a drive voltage was applied to the organic EL element by a DC driving system, a pulse driving system of a duty ratio of 50 %, a pulse driving system of a duty ratio of 10 %, and a pulse driving system of a duty ratio of 1 %, and continuous luminescence experiments were respectively conducted at room temperature under driving conditions, that is, an initial average luminance of 1000 cd/m², to examine the amount of luminance reduced with an elapse of time. In this case, the initial value of an average drive current was approximately 27 mA/cm².

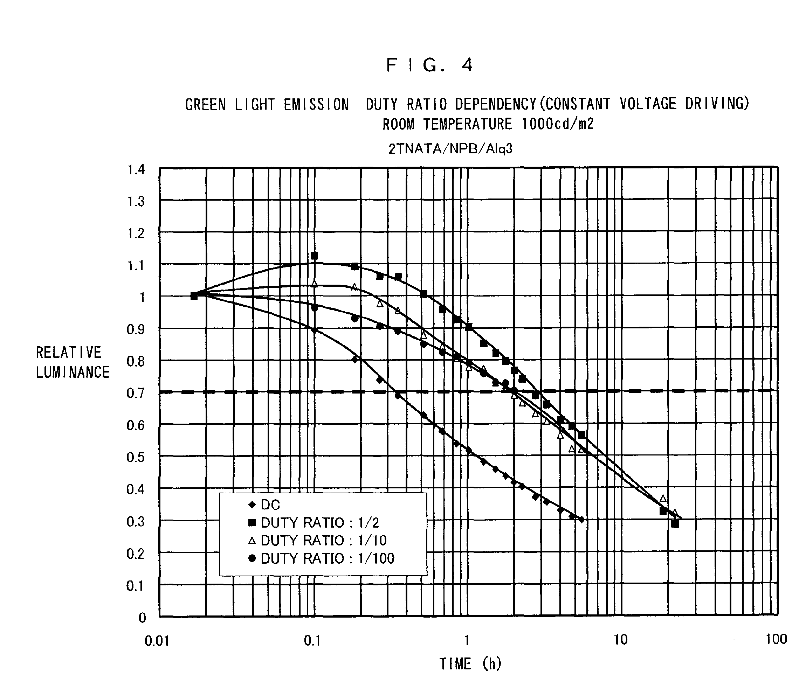

Fig. 4 is a diagram showing the results of measurement of the duty ratio dependency of the life of the organic EL element in the example 2. In Fig. 4, the horizontal axis represents time, and the vertical axis represents relative luminance in a case where the initial average luminance is set to one.

As shown in Fig. 4, the 70 % life was approximately 0.32 hours in DC driving, while being lengthened to 2.6 hours in pulse driving at a duty ratio of 50 %. However, the 70 % life was approximately two hours in both pulse driving at a duty ratio of 10 % and pulse driving at a duty ratio of 1 %, which was shorter than that in the pulse driving at a duty ratio of 50 %.

When the results in the example 1 and the results in the example 2 were compared with each other, therefore, it is found that the improvement rate of life is increased by pulse driving at a low duty ratio at the time of driving in low luminance or low current density, while being conversely reduced when the duty ratio is reduced at the time of driving in high luminance or high current density.

### [Example 3]

In the example 3, a luminescent layer 5 obtained by doping methyl quinacridone into Alq₃ was used. The structure of the other portions in the organic EL element in the example 3 is the same as the structure of the organic EL element in the example 1. In this case, methyl quinacridone was doped into Alq₃ in the luminescent layer 5, thereby making it possible to obtain an organic EL element emitting green light at higher efficiency, as compared with that in a case where a luminescent layer 5 composed of only Alq₃ is used.

A drive voltage was applied to the organic EL element by a DC driving system, a pulse driving system of a duty ratio of 50 %, and a pulse driving system of a duty ratio of 10 %, and continuous luminescence experiments were respectively conducted at room temperature under driving conditions, that is, an initial average luminance of 500 cd/m², to examine the amount of luminance reduced with an elapse of time. The frequency of a pulse voltage was set to 60 Hz. In this case, the initial value of an average drive current was approximately 10 mA/cm².

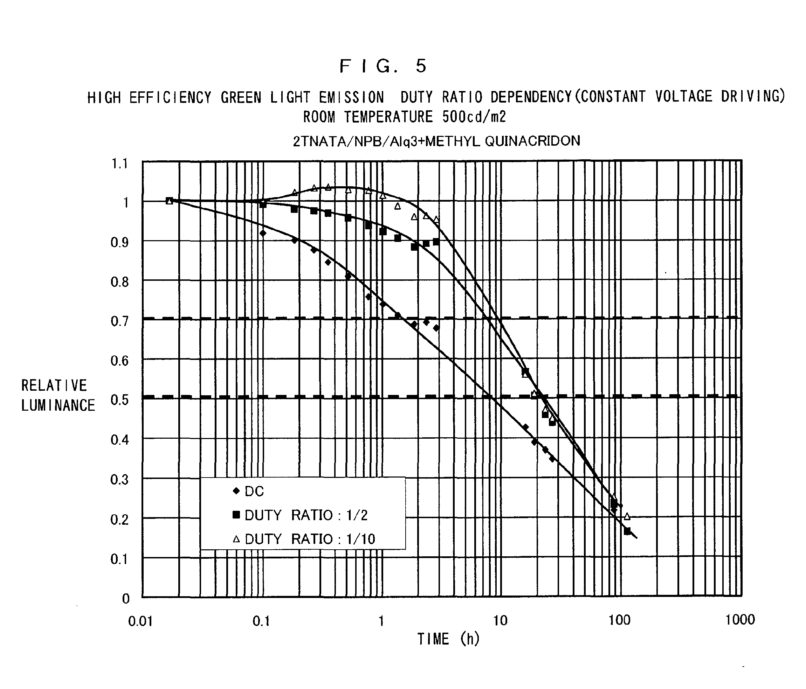

Fig. 5 is a diagram showing the results of measurement of the duty ratio dependency of the life of the organic EL element in the example 3. In Fig. 5, the horizontal axis represents time, and the vertical axis represents relative luminance in a case where the initial average luminance is set to one.

As shown in Fig. 5, the 70 % life was approximately 1.2 hours in DC driving, while being lengthened to approximately 9 hours in pulse driving at a duty ratio of 50 % and approximately 10 hours in pulse driving at a duty ratio of 10 %.

### [Example 4]

In the example 4, a luminescent layer having a thickness of 200 Å obtained by doping Rubrene having a molecular structure of a chemical formula (4) into à-NPB was formed on a hole injection layer 3 having a thickness of 500 Å composed of 2-TNATA, an electron transport layer having a thickness of 400 Å composed of Alq₃ was formed on the luminescent layer, and a cathode 6 was formed on the electron transport layer. The organic EL element can emit yellow light at high efficiency.

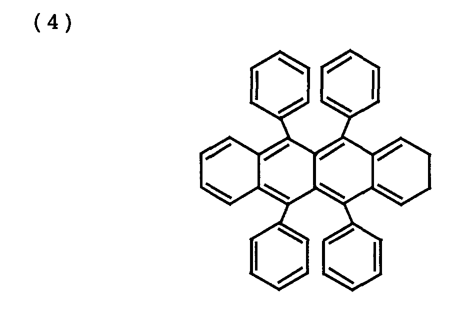

A drive voltage was applied to the organic EL element by a DC driving system and a pulse driving system, and continuous luminescence experiments were conducted at room temperature, to examine the amount of luminance reduced with an elapse of time.

In the DC driving system, a predetermined voltage was continuously applied to the organic EL element. In the pulse driving system, a pulse voltage having a duty ratio of 50 %, a pulse voltage having a duty ratio of 10 %, and a pulse voltage having a duty ratio of 1 % were applied to the organic EL element. The frequency of the pulse voltage was set to 60 Hz.

In any of DC driving, pulse driving at a duty ratio of 50 %, pulse driving at a duty ratio of 10 %, and pulse driving at a duty ratio of 1 %, the driving conditions were adjusted such that the initial average luminance would be 100 cd/m². The continuous luminescence experiments were conducted by constant voltage driving for keeping an average drive voltage constant. Under the driving conditions, the initial value of an average drive current was approximately 1.7 mA/cm².

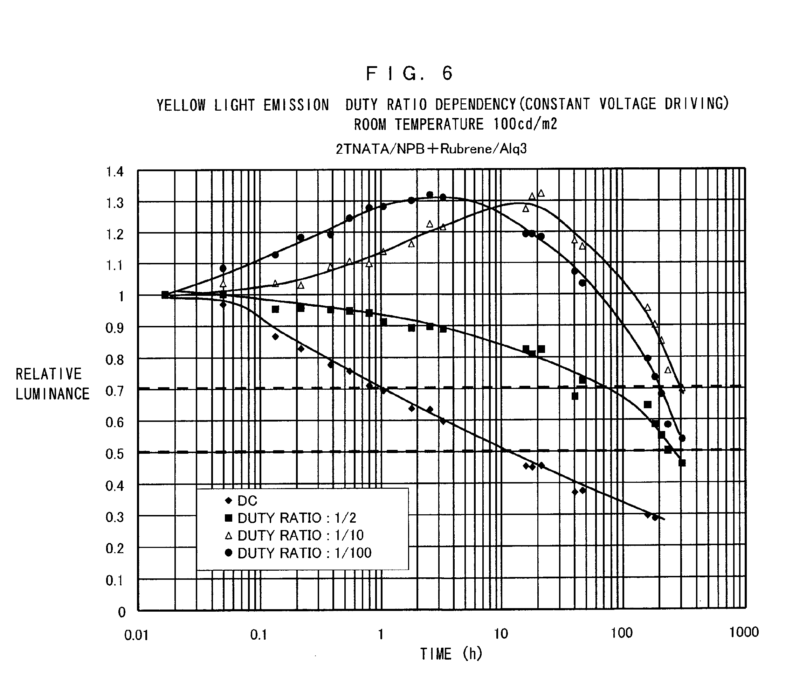

Fig. 6 is a diagram showing the results of measurement of the duty ratio dependency of the life of the organic EL element in the example 4. In Fig. 6, the horizontal axis represents time, and the vertical axis represents relative luminance in a case where the initial average luminance is set to one.

As shown in Fig. 6, the 70 % life was approximately one hour in the DC driving and approximately 65 hours in the pulse driving at a duty ratio of 50 %, while being significantly improved to 200 hours in the pulse driving at a duty ratio of 10 % and 300 hours in the pulse driving at a duty ratio of 1.

### [Example 5]

In the example 5, a luminescent layer 5 obtained by doping DCJTB having a molecular structure of a chemical formula (5) into Alq₃ as a dopant for red light emission as well as doping Rubrene as a luminescence assist dopant was used. That is, the organic EL element has a stacked structure comprising a hole injection layer 3 having a thickness of 500 Å composed of 2-TNATA, a hole transport layer 4 having a thickness of 150 Å composed of á-NPB, and a luminescent layer 5 having a thickness of 400 Å composed of Alq₃, DCJTB and Rubrene. The organic EL element can emit red light. However, it is lower in luminous efficiency, as compared with those in the organic EL elements emitting green light in the examples 1 to 3 and the organic EL element emitting yellow light in the example 4.

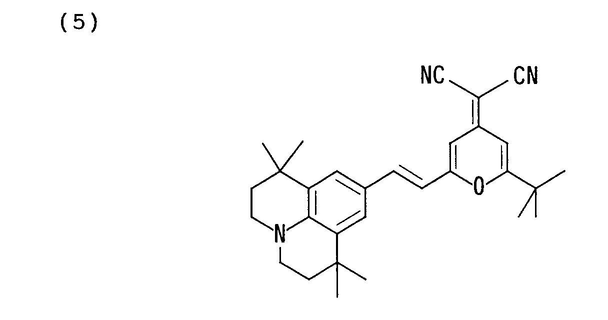

A drive voltage was applied to the organic EL element by a DC driving system and a pulse driving system, and continuous luminescence experiments were conducted at room temperature, to examine the amount of luminance reduced with an elapse of time.

In the DC driving system, a predetermined voltage was continuously applied to the organic EL element. In the pulse driving system, a pulse voltage having a duty ratio of 50 % and a pulse voltage having a duty ratio of 10 % were applied to the organic EL element. The frequency of the pulse voltage was set to 60 Hz.

In any one of the DC driving, the pulse driving at a duty ratio of 50 %, and the pulse driving at a duty ratio of 10 %, the driving conditions were adjusted such that the initial average luminance would be 75 cd/m². The continuous luminescence experiments were conducted by constant voltage driving for keeping an average drive voltage constant. Under the above-mentioned driving conditions, the initial value of an average drive current was approximately 15.6 mA/cm².

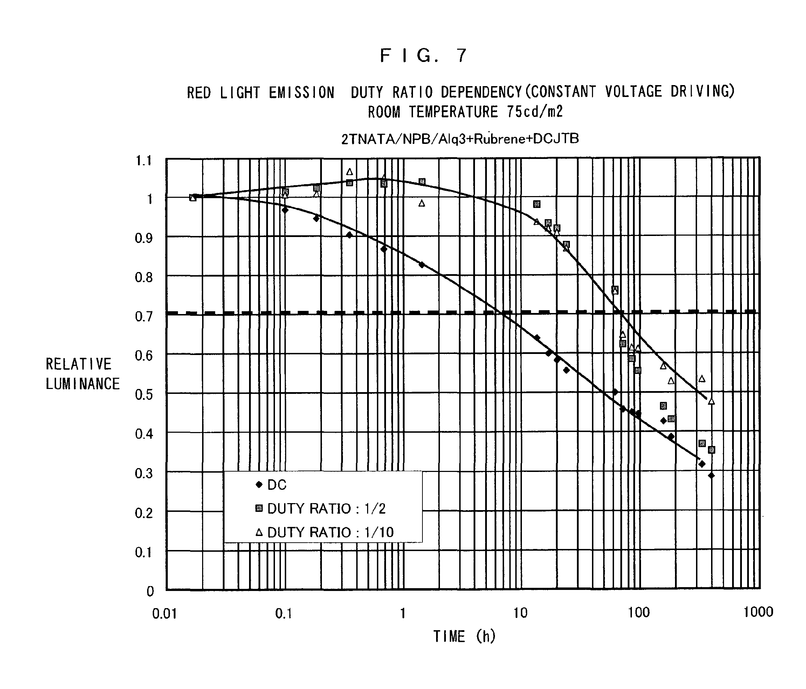

Fig. 7 is a diagram showing the results of measurement of the duty ratio dependency of the life of the organic EL element in the example 5. In Fig. 7, the horizontal axis represents time, and the vertical axis represents relative luminance in a case where the initial average luminance is set to one.

As shown in Fig. 7, the 70 % life was approximately 7 hours in the DC driving, while being improved to approximately 63 hours in the pulse driving at a duty ratio of 50 % and the pulse driving at a duty ratio of 10 %.

The results of experiments under various conditions were further added to the results of the continuous luminescence experiments in the examples 1 to 5, to examine the relationship between the average drive current and the life. The added results of the experiments were results in a case where the initial average luminance was set to 50 cd/m² in the organic EL element, emitting green light, comprising a luminescent layer composed of Alq₃, a case where the initial average luminance was set to 10 cd/m² in the organic EL element, emitting red light, comprising a luminescent layer obtained by doping DCJTB and Rubrene into Alq₃, and a case where the initial average luminance was set to 2000 cd/m² in the organic EL element, emitting yellow light, comprising a luminescent layer obtained by doping Rubrene into α-NPB.

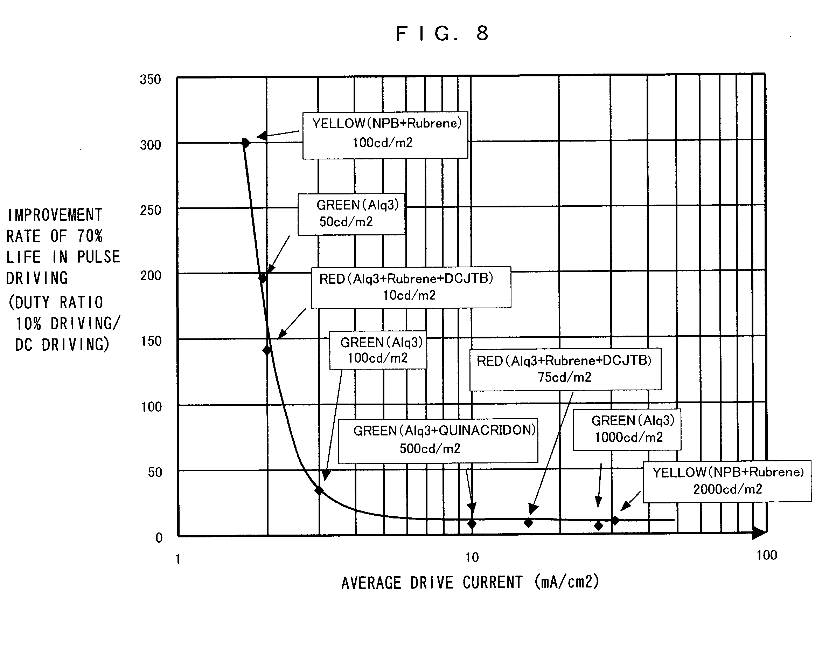

Fig. 8 is a diagram showing the relationship between the initial value of the average drive voltage and the life. In Fig. 8, the horizontal axis represents the initial value of the average drive current, and the vertical axis represents the ratio of the 70 % life in the pulse driving at a duty ratio of 10 % to the 70 % life in the DC driving as the improvement rate of the life.

As shown in Fig. 8, it is found that the improvement rate of the life by the pulse driving at a duty ratio of 10 % is low when the initial value of the average drive current is more than 3 mA/cm² irrespective of the difference in the luminescent color and the element structure, while being significantly increased when the initial value of the average drive current is not more than 3 mA/cm².

As described in the foregoing, it is found that the maximum effect of attaining long life is obtained by driving the organic EL element under driving conditions, that is, a duty ratio of not more than 10 %, an average drive current of not more than 3 mA/cm², and an average drive voltage of not more than 4 volts in consideration of the fact that the same effect of improving life can be also obtained, if the duty ratio of the pulse voltage is not more than 10 %, in cases where the duty ratio of the pulse voltage is 1 % and is 0.2 %.

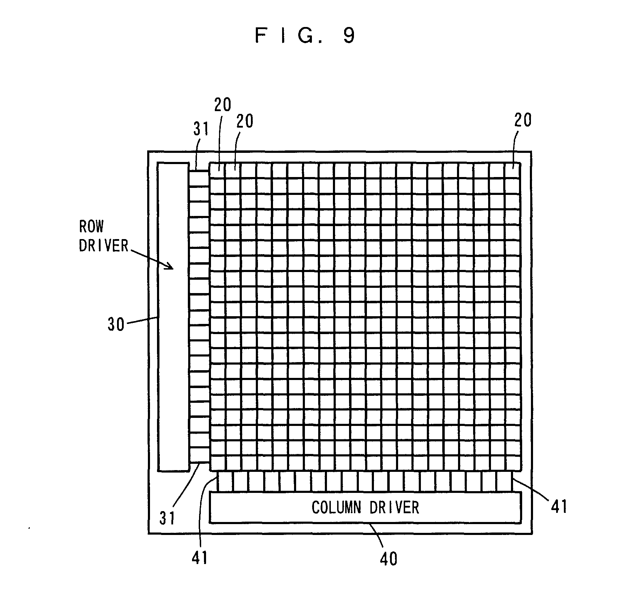

Fig. 9 is a block diagram showing an example of the configuration of a display of a simple matrix system (a passive system) using the driving device according to the present invention.

In the display shown in Fig. 9, a plurality of organic EL elements having the structure shown in Fig. 1 are arranged in the form of a matrix of n rows and m columns on a common substrate, where n and m are arbitrary integers.

Anodes 2 (see Fig. 1) of a plurality of organic EL elements 20 forming each row are connected to a driving signal line 31. A plurality of driving signal lines 31 corresponding to a plurality of rows are connected to a row driver 30. Driving signals are respectively applied to the plurality of driving signal lines 31 by the row driver 30.

Cathodes 6 (see Fig. 1) of a plurality of organic EL elements 20 forming each column are connected to a column selection signal line 41. A plurality of column selection signal lines 41 corresponding to a plurality of columns are connected to a column driver 40. Column selection signals are successively applied to the plurality of column selection signal lines 41 by the column driver 40.

The driving signal applied to the driving signal line 31 by the row driver and the column selection signal applied to the column signal selection line 41 by the column driver 40 are set such that a pulse voltage having a duty ratio of not more than 10 % is applied to the organic EL element 20 which should emit light, and no pulse voltage is applied to the organic EL element which does not emit light.

In this case, an average drive current flowing through the organic EL element 20 which should emit light is set to not more than 3 mA/cm², and an average drive voltage applied to the organic EL element 20 was set to not more than 4 volts. Consequently, a high definition display of a simple matrix system is realized.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A method of driving an organic electroluminescence element including an organic material layer, comprising the step of:
applying a pulse voltage having a duty ratio of not more than 10 % between electrodes in said organic electroluminescence element, setting an average drive current flowing through said organic electroluminescence element to not more than 3 mA/cm², and setting an average drive voltage applied between the electrodes in said organic electroluminescence element to not more than 4 volts.

2. The driving method according to claim 1, wherein
said step of setting the average drive voltage to not more than 4 volts comprises the step of setting said average drive voltage to not more than 1 volt.

3. The driving method according to claim 1, wherein
said organic material layer includes an aluminum quinolinol complex.

4. An apparatus for driving an organic electroluminescence element including an organic material layer, comprising:
a pulse voltage application circuit for applying a pulse voltage having a duty ratio of not more than 10 % between electrodes in said organic electroluminescence element, wherein
an average drive current flowing through said organic electroluminescence element is set to not more than 3 mA/cm², and an average drive voltage applied between the electrodes in said organic electroluminescence element is set to not more than 4 volts.

5. The driving apparatus according to claim 4, wherein
said average drive voltage is set to not more than 1 volt.

6. The driving apparatus according to claim 4, wherein
said organic electroluminescence element comprises an organic material layer containing an aluminum quinolinol complex.

7. A display comprising:
one or a plurality of organic electroluminescence elements each including an organic material layer, and
a driving device for applying a pulse voltage having a duty ratio of not more than 10 % between electrodes in each of the organic electroluminescence elements, wherein
an average drive current flowing through each of the organic electroluminescence elements is set to not more than 3 mA/cm², and an average drive voltage applied between the electrodes in each of the organic electroluminescence elements is set to not more than 4 volts.

8. The display according to claim 7, wherein
said driving device is a driving device of a simple matrix system.

9. The display according to claim 7, wherein
the average drive voltage applied between the electrodes in each of the organic electroluminescence elements is set to not more than 1 volt.

10. The display according to claim 7, wherein
said organic material layer contains an aluminum quinolinol complex.
